# EUROPEAN PATENT APPLICATION

(11) **EP 1 253 636 A1**
(43) Date of publication of application: **30.10.2002**
(21) Application number: 01967704.6
(22) Date of filing: 17.09.2001
(51) Int. Cl.: H01L 23/40

(54) **ELECTRONIC EQUIPMENT**

(30) Priority: 19.09.2000 JP 2000283018; 09.08.2001 JP 2000242874
(71) Applicant: MATSUSHITA ELECTRIC INDUSTRIAL CO., LTD., Kadoma-shi, Osaka 571-8501 (JP)
(72) Inventor: SEGI, Hiroshi, Matsusaka-shi, Mie 515-0102 (JP); TANIGUCHI, Toshiyuki, Matsusaka-shi, Mie 515-0824 (JP); MURAKAMI, Takaharu, Matsusaka-shi, Mie 515-0045 (JP)
(74) Representative: Balsters, Robert
(86) International application number: PCT/JP01/08053
(87) International publication number: WO 02/025731

(57) **Abstract**

Electronic equipment comprising a wiring board, electronic component mounted on the wiring board and having a heat dissipation portion on the surface thereof, and an insulating heat dissipation plate thermally connected to the electronic component, wherein the heat dissipation portion is directly connected to the heat dissipation plate with heat conductive bonding materials. The heat dissipation plate is a ceramic plate having at least one land for connecting electronic component or a resin plate containing highly heat conductive material. By directly connecting the insulating heat dissipation plate to electronic component generating heat, an insulating plate between the heat dissipation plate and the electronic component used in a conventional method becomes not required. Consequently, it is possible to enhance a heat dissipation effect of electronic component in electronic equipment.

## Description

### TECHNICAL FIELD

The present invention relates to an electronic equipment with heat generating electronic components mounted thereon.

### BACKGROUND ART

Conventional electronic equipment with heat generating electronic components mounted thereon is structurally as follows. That is, conventional electronic equipment includes a wiring board and electronic components mounted on the wiring board. Of the electronic components, metallic plate is thermally connected to those generating heat, and heat from the electronic components is radiated via the metallic plate.

The above conventional example involves such problem that the effect of heat dissipation from electronic components is insufficient. That is, in the conventional example, as described above, metallic plate is thermally connected to heat generating electronic components, but in this case, there is provided an insulating plate made of resin or inorganic material between electronic component and metallic plate. However, the insulating plate causes the heat dissipation effect to become insufficient.

The present invention is intended to provide a method of mounting electronic components improved in heat dissipation from heat generating electronic components and also to provide electronic equipment using the electronic components.

### DISCLOSURE OF THE INVENTION

Electronic equipment of the present invention comprises a wiring board, electronic component mounted on the wiring board and having a heat dissipation portion on the surface thereof, and an insulating heat dissipation plate thermally bonded to the electronic component, wherein the heat dissipation portion is directly connected to the heat dissipation plate with heat conductive bonding materials. The heat dissipation plate for electronic equipment of the present invention is a ceramic plate having at least one land for connecting electronic component or a resin plate including highly heat conductive material.

By directly connecting an insulating heat dissipation plate to heat generating electronic component, it becomes unnecessary to displose an insulating plate as used in a conventional method between heat dissipation plate and electronic component. As a result, the effect of heat dissipation from electronic components in electronic equipment may be enhanced.

### BRIEF DESCRIPTION OF THE DRAWINGS

Fig. 1 is a perspective view of electronic equipment unit in the first preferred embodiment of the present invention.
Fig. 2 is a exploded perspective view showing the states of ceramic plate and FET in the present invention.
Fig. 3 is a front view showing a ceramic plate and wiring board in the present invention.
Fig. 4 is a perspective view of a heat dissipation plate in the second preferred embodiment of the present invention.
Fig. 5 is a perspective view of another heat dissipation plate in the second preferred embodiment of the present invention.
Fig. 6 is a side view of still another heat dissipation plate in the second preferred embodiment of the present invention.
Fig. 7 is a perspective view of yet another heat dissipation plate in the second preferred embodiment of the present invention.
Fig. 8 is a perspective view of an electronic equipment cover in the third preferred embodiment of the present invention.

### DETAILED DESCRIPTION OF PREFERRED EMBODIMENT

The preferred embodiments of the present invention will be described in the following with reference to the drawings.

### First preferred embodiment

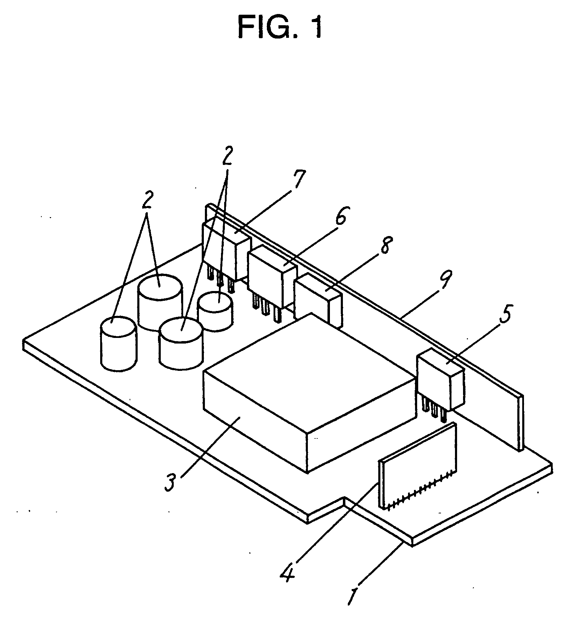

In Fig. 1, on the top surface of wiring board 1 is mounted electronic components such as electrolytic capacitor 2, transformer 3, wiring module 4, FET 5, 6, 7, and diode 8, thereby comprising an electronic equipment unit.

As described above, a plurality of electronic components are mounted on the wiring board 1. Particularly, FET 5, 6, 7 and diode 8 are accompanied by considerable heat generation when power is applied thereto.

In this preferred embodiment, these electronic components are soldered to ceramic plate 9 as one of heat dissipation plates. In the present preferred embodiment, solder is used as an example of heat conductive bonding materials.

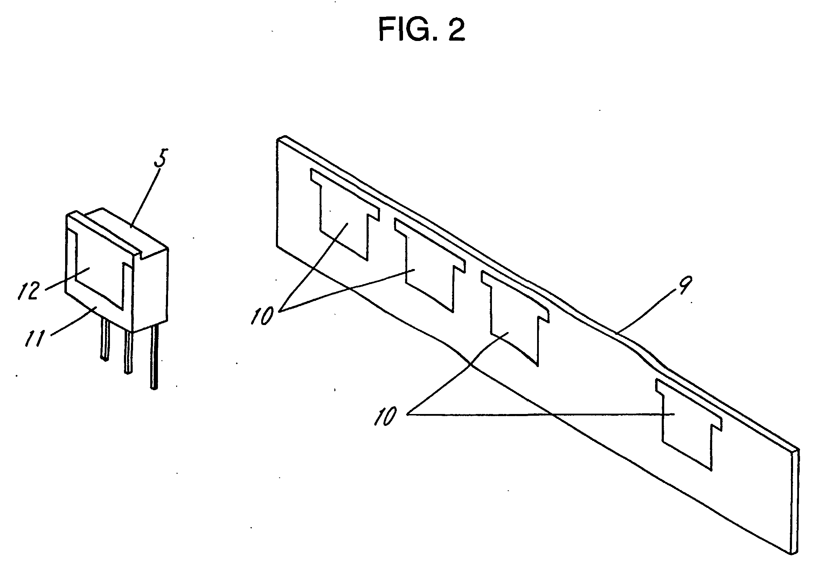

The essential points of the present invention will be further described in detail with reference to Fig. 2.

As shown in Fig. 2, ceramic plate 9 is provided with soldering lands 10 with a predetermined distance apart from each other. On the other hand, referring to the individual electronic components mentioned above, a periphery of FET 5, for example, is covered with mold resin 11 except heat dissipation portion 12 exposed at the back side as shown in Fig. 2. Here, the heat dissipation portion 12 and land 10 are same in shape as shown in Fig. 2. Further, in the present preferred embodiment, the heat dissipation portion 12 and land 10 are T-shaped in that the upper portion is broader than the lower portion.

And, the heat dissipation portion 12 and land 10 are bonded to each other by soldering, and in this case, since the land 10 and heat dissipation portion 12 are nearly T-shaped, the deflection between FET 5 and land 10 during soldering will be lessened due to self-alignment effects.

Various ceramics metallizing means generally employed for ceramic parts may be used for forming the land. As metallizing means, there are many methods and processes such as a high-temperature firing conductive paste method, wet plating process, vacuum deposition process, sputtering method, CVD method, and metal spraying method. Any kind of metallic materials can be selected as the land forming material according to the bonding material used.

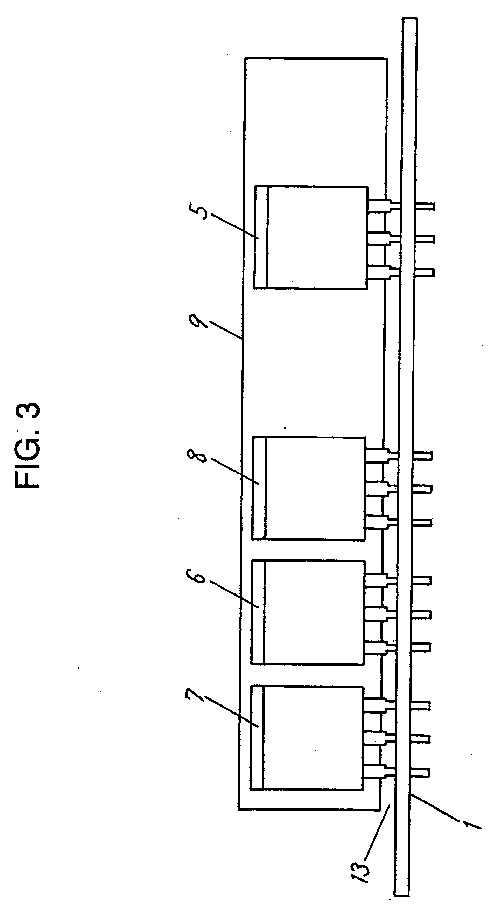

Also, by providing a plurality of lands 10 with a predetermined distance apart from each other on the ceramic plate 9 and soldering the heat dissipation portions 12 of electronic components to the lands 10 as shown in Fig. 1, a plurality of electronic components can be easily thermally bonded to the ceramic plate 9 as shown in Fig. 3.

In the electronic equipment of the present preferred embodiment, a clearance 13 is formed between a bottom end of the ceramic plate 9 and the top surface of the wiring board 1.

That is, the ceramic plate 9 is held by the electronic components and mounted on the board, having the clearance 13 at the bottom thereof against the wiring board. In this way, air may flow through the clearance 13, improving the ventilation and enhancing the heat dissipation effect.

In this preferred embodiment, a solder is used as a heat conductive bonding material, but the bonding material is not limited to the solder. It is possible to use any type of highly heat conductive material that may bond electronic component to the wiring board. As examples of other materials, alloys containing tin, indium or bismuth, and conductive adhesives containing a large quantity of silver, copper or the like can also be used.

### Second preferred embodiment

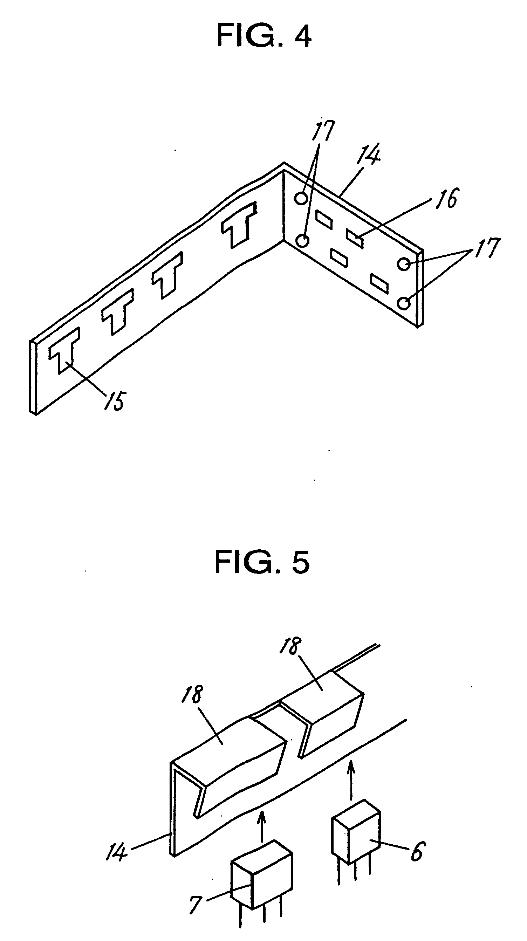

Fig. 4 shows an example of heat dissipation plate for electronic components in the second preferred embodiment of the present invention. In this preferred embodiment, there is provided a resin plate 14 including highly heat conductive material such as ceramic fillers or the like as a heat dissipation plate in place of the ceramic plate 9 used in the first preferred embodiment. The resin plate 14 is provided with a plurality of soldering lands 15 with a predetermined distance apart from each other, and the heat dissipation portion 12 of electronic component shown in Fig. 2 is soldered to each land 15.

Since the resin plate 14 can be more easily molded than the ceramic plate 9, the end portion thereof is bent 90° to provide lands 16 for mounting other electronic component as shown in Fig. 4.

Also, vent hole 17 is made in the resin plate 14, and the air flowing through the vent hole 17 may enhance the heat dissipation effect.

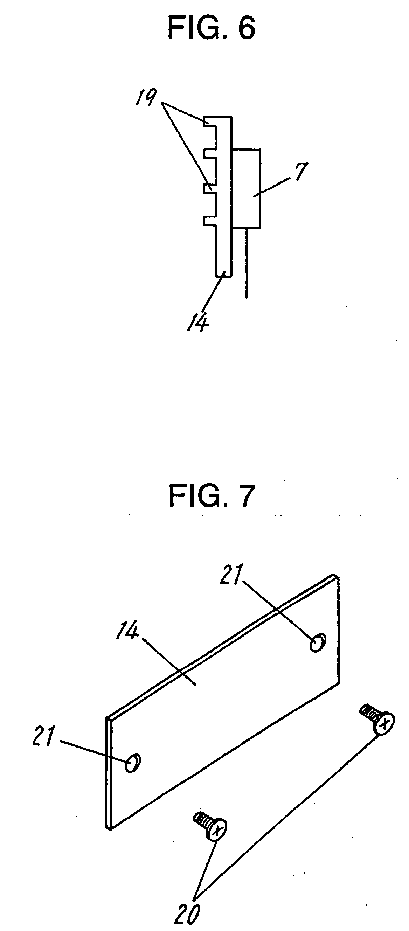

Since the resin plate 14 has excellent processability, it is possible to integrally form holding portion 18 to hold electronic component on the resin plate 14 as shown in Fig. 5 and to integrally form heat dissipation fin 19 as shown in Fig. 6 and to make screw hole 21 for electronic component screw 20 as shown in Fig. 7.

### Third preferred embodiment

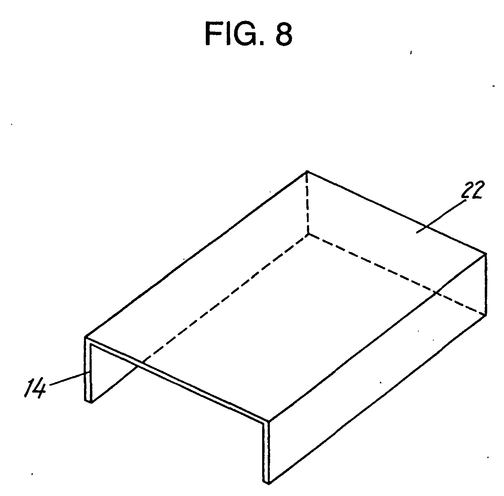

The electronic equipment cover in the third preferred embodiment of the present invention will be described with reference to Fig. 8.

In this preferred embodiment, resin plate 14 and electronic equipment cover 22 are integrally molded. Thus, using the resin plate 14 as cover 22, the heat dissipation area can be increased, and since the heat dissipation plate is facing the outermost portion of equipment, the heat dissipation effect will be enhanced in particular.

As for integral molding, it is preferable to form the cover 22 by using resin with highly heat conductive material mixed in. As another method of molding, it is possible to form the resin plate 14 portion by using resin with highly heat conductive material mixed in and the cover 22 portion by using other molding resin, that is, to employ what is called a two-color molding method.

In the electronic equipment of the present preferred embodiment, connectors may be provided on the wiring board for connecting heat generating components previously bonded to the cover or to connect lead wires from heat generating components to another wiring board.

Further, it is possible to form wiring patterns on the resin plate 14 inside the case, and to mount all components on the resin plate 14 as surface-mounting components, making it unnecessary to use a wiring board.

### INDUSTRIAL APPLICABILITY

As described above, the electronic equipment of the present invention comprises a wiring board, electronic component mounted on the wiring board, and an insulating heat dissipation plate thermally bonded to the electronic component, wherein the electronic component has a heat dissipation portion on the surface thereof, and the electronic component is bonded to the heat dissipation plate portion corresponding to the heat dissipation portion by using heat conductive bonding materials. According to the present invention, it is unnecessary to dispose an insulating plate which is a thermal resistance between electronic component and heat dissipation plate, and it becomes possible to greatly enhance the heat dissipation effect of the heat generated from the electronic components.

### Reference Numerals

- 1: Wiring board
- 2: Electrolytic capacitor
- 3: Transformer
- 4: Wiring module
- 5,6,7: FET
- 8: Diode
- 9: Ceramic plate
- 10, 15, 16: Land
- 11: Mold resin
- 12: Heat dissipation portion
- 13: Clearance
- 14: Resin plate
- 17: Vent hole
- 18: Holding portion
- 19: Heat dissipation fin
- 20: Screw
- 21: Hole
- 22: Cover

## Claims

1. Electronic equipment comprising:
a wiring board;
an electronic component mounted on said wiring board and having a heat dissipation portion on a surface thereof; and
an insulating heat dissipation plate thermally connected to said electronic component,
wherein said heat dissipation portion is directly connected to said heat dissipation plate with heat conductive bonding material.

2. The electronic equipment of claim 1, wherein said heat dissipation plate is a ceramic plate having at least one land for connecting said electronic component.

3. The electronic equipment of claim 1, wherein said heat dissipation plates are disposed on said wiring board with a predetermined distance apart from each other.

4. The electronic equipment of claim 1, wherein said heat dissipation plate is a resin plate containing a highly heat conductive material having at least one land for connecting said electronic component.

5. The electronic equipment of claim 4, wherein said heat dissipation plates are disposed on said wiring board with a predetermined distance apart from each other.

6. The electronic equipment of claim 4, wherein said heat dissipation plate further has a land for connecting electronic component other than the electronic component having a heat dissipation portion on a surface thereof.

7. The electronic equipment of claim 4, wherein said heat dissipation plate further has a holding portion for holding electronic component.

8. The electronic equipment of claim 4, wherein said heat dissipation plate further includes a heat dissipation fin portion integrally formed.

9. The electronic equipment of claim 4, wherein said heat dissipation plate further has a vent hole.

10. The electronic equipment of claim 4, wherein said heat dissipation plate further has a screw hole.

11. The electronic equipment of claim 4, wherein said heat dissipation plate is unitary formed with an electronic equipment cover.
